# EUROPEAN PATENT APPLICATION

(11) **EP 2 528 124 A1**
(43) Date of publication of application: **28.11.2012**
(21) Application number: 11004228.0
(22) Date of filing: 23.05.2011
(51) Int. Cl.: H01L 35/32

(54) **A power generator**

(71) Applicant: Holdingselskabet TEG af 2011 ApS, 4653 Karise (DK)
(72) Inventor: Lindeburg, Niels, 4653 Karise (DK)
(74) Representative: Skov, Anders

(57) **Abstract**

The present invention relates to a power generator comprising a heat absorbing substrate with a first heat absorbing side and a second heat releasing side and one or more thermo electric generators having a first heat receiving side and a second cooling side. The one or more thermo electric generators are in contact with the heat releasing side of the heat absorbing substrate with their first heat receiving side to allow heat to be transferred from the heat absorbing substrate to the one or more thermo electric generators and where the area of the heat releasing side in contact with and surrounding a thermo electric generator is at least four times larger than the area of the first heat receiving side of the thermo electric generator.

## Description

The present invention relates to a power generator comprising a heat absorbing substrate with a first heat absorbing side and a second heat releasing side and one or more thermo electric generators having a first heat receiving side and a second cooling side.

Thermo electric generator technology is based on the well-known concept that a temperature differential may be converted into electricity and vice versa. Namely, the Seebeck effect which is the conversion of a temperature differential directly into electricity, and the Peltier effect which is the production of a temperature differential from a difference in electric potential. A Thermo electric generator is normally made from two different sheets of plates of semi conducting material such as e.g. semi conducting metal. The sheets are electrical separated, but thermal connected at two end points. However, the construction and use of thermo electric generators is also a well-known technical field.

Thermo electric generators hold great promise for widespread use due to their solid state structure, silent operation, high reliability and long service life. Thermo electric generators used for power generation can produce electricity from virtually any source of heat, which could enable many energy conversion processes to increase efficiency, reduce pollutant emissions and lower costs. Thermo electric generators used for heating or cooling can achieve very sensitive temperature control, and thermo electric generators used for cooling do not require volatile working fluids.

Radiation from the sun is the primary source for energy on Earth, however, depending on the location the energy contained in the radiation from the sun will vary. On the northern or southern hemisphere the effect from the sun may be between 600 and 1000Watt per square meter, closer to equator, e.g. in Sahara the effect may be as high as between 1200 and 1300Watt per square meter.

Although, use of radiation from sun too power thermo electric device have been attempted, these attempts have not been very successful as the efficiency of the thermo electric generators was to low to provide any effect that was of economical and industrial feasibility. Examples of the prior use of sunlight to power thermo electric generators are e.g. disclosed in German patent document DE 202008009979 and US patent document 20080142069.

Thus, it has hitherto not been interesting to use thermo electric generators for power production in a scale that is of commercial interest as the efficiency has been to low in relation to the required investments.

The object of the present invention is to provide a power generator with thermo electric generators that has a higher efficiency.

The present invention provides a power generator based on thermo electric generators that has a surprising high efficiency and which power generator is easy to install and use and, moreover, can be acquired at relative low costs.

Consequently, the present invention relates to a power generator comprising a heat absorbing substrate with a first heat absorbing side and a second heat releasing side and one or more thermo electric generators having a first heat receiving side and a second cooling side, wherein the one or more thermo electric generators are in contact with the heat releasing side of the heat absorbing substrate with their first heat receiving side to allow heat to be transferred from the heat absorbing substrate to the one or more thermo electric generators and where the area of the heat releasing side in contact with and surrounding a thermo electric generator is at least four times larger than the area of the first heat receiving side of the thermo electric generator.

In principle the heat absorbing substrate may be any material that can absorb and transport heat and it may be a material based on metals, polymers or ceramics having good heat conductive properties. Preferably the heat absorbing substrate is in the form of thin plates or strips to which the thermo electric generator may be attached in heat conductive contact. The heat conductive attachment can be obtained by use of heat conductive and heat resistant glue such as FisherElectric, a heat conductive pasta from the company 3M, or a similar heat conductive pasta from the company Danfoss. The thermo electric generators are attached to the heat releasing side of the substrate, which second heat releasing side normally is opposite to the first heat absorbing side. To improve the heat absorbing properties the first heat absorbing side may be painted or coated with a colour or material that increases the heat absorption, e.g. a black colour. Furthermore, the substrate and the thermo electric generators may be placed in a box comprising at least one side made form glass. Such an encapsulation may significantly increase the heat input to the substrate.

The heat absorbing side of the heat absorbing substrate may be adapted to be directly exposed to solar radiation or the heat absorbing substrate may adapted to absorb heat from a heat absorbing media, e.g. from a fluid such as water. In the latter case the power generator may be incorporated in a solar thermal collector plant.

The thermo electric generators used according with the invention are commercially available thermo electric generators referred to as e.g. HTTEM or TEG 3 or TEG 7. The thermo electric generators have effects in the range from about 3 to about 10Watt or even up to 15 or 20Watt.

According to the invention it has been realised, contrary to ordinary expectations, that it is possible to achieve efficiency and an economically satisfactory result using thermal electrical generators to convert solar energy into electric power.

The reason for this is based on the unexpected finding that the heat absorbing area for providing heat to first heat receiving side of the thermal electric generator should be at least four times larger than the area or the first heat receiving side, conveniently the heat absorbing area should be four to hundred times larger than the area of the first heat receiving side, preferably the heat absorbing side is between ten to fifty times larger than the area of the first heat receiving side.

Moreover, to obtain an efficient power generator where at least two thermo electric generators are in heat conductive contact with the heat releasing side of the heat absorbing substrate it has been found that the mutual distance between each thermo electric generator should be at least 5cm. The reason for this is that mutual distance between the two or more thermal power generators of at least 5cm allows for at very efficient and substantially sufficient heat supply to the heat receiving side of each thermal power generator.

To obtain the best possible properties of the power generator it is Preferred that the cooling side of the thermo electric generator is in contact with a cooling media. The cooling media may be air, however, to obtain a more efficient cooling it is preferred that the cooling media is a liquid, which has a higher heat capacity. The liquid may be water, an oil or alternatively e.g. pressurised nitrogen or carbon dioxide. However, the preferred cooling media is water, which has an excellent heat capacity and, thereby, capacity to remove a substantial amount of heat from the cooling side of the thermo electric generator. Water can be obtained at low cost and is easy to reuse. A liquid cooling media is provided to the cooling side of the thermo electric generator in a tube of heat conductive material, where the exterior side of the tube is in contact with cooling side.

Furthermore, to obtain a sufficiently high output of the power generator according to the invention the difference in temperature between the first heat receiving side and the second cooling side of the thermo electric generator is preferably in the range of 30 to 300K, more preferably in the range of 50 to 250K. This is in accordance with principle that if the difference in temperature is higher the output is higher.

Although the heat absorbing substrate may comprise any material with good heat absorbing properties combined with good heat conductive properties it is, however, preferred that a part of the heat absorbing substrate comprises copper or aluminium, which metals are known to be extremely good heat absorbing and heat conductive materials.

For the purpose of obtaining a realisable design of the power generator it is preferred that each thermo electric generator has a maximum effect of from 3 to 10Watt or even up to 15 or 20Watt. Higher effects are most likely to be expected in the future as the technology is maturing. The present invention is, however, applicable with any maximum effect of the thermo electric generators.

In accordance with the above preferred effects of the thermo electric generators it is preferred that the power generator comprises 5 to 40 thermo electric generators per square meter of heat absorbing substrate, and suitable 10-30 thermo electric generators per square meter of heat absorbing substrate. In this way it is possible to design a compact and efficient power generator and, moreover, if the number of thermo electric generators becomes too high the efficiency of the thermo electric generators may decrease. However, the exact number of thermo electric generator per square meter of heat absorbing substrate depends on the specific thermo electric generator and the location where the power generator is to be used.

The thermo electric generators may be connected in parallel or in series, however for most practical uses it is preferred that the thermo electric generators are electrical connected in series. The thermo electric generators are also connected to an inverter that inverts the electricity from the thermo electric generators into electric power with a desired voltage. The power generator according to the invention comprises all necessary wiring to transfer the electric power from the thermo electric generators to an inverter.

In a preferred embodiment of the power generator the heat absorbing substrate is prefabricated as strips in a heat conducting material such as e.g. copper or aluminium. The prefabricated strips may be adapted with tracks for easy mounting of thermo electric generators. The prefabricated strips may be coated with a heat absorbing material. The prefabricated strips may facilitate production of the power generator according to the invention.

For the purpose of improving the efficiency of the power generator according to the invention the power generator comprises an embodiment where the heat absorbing substrate and the thermo electric generators are placed in a box having at least one side made from glass. The side made from glass is intended to face the sun and in this way the box serves to provide a greenhouse effect whereby more heat can be transferred to the heat absorbing substrate and the thermo electric generators.

The power generator may also comprise a cooling module adapted to fit with the cooling side of the thermo electric generators. The cooling module may be a special shaped tube member adapted to fit with the cooling side of the thermo electric generators and cool the cooling side by means of a cooling medium such as water.

In a further preferred embodiment that may facilitate the production of the power generator the heat absorbing substrate is prefabricated strips, preferably adapted with tracks for mounting thermo electric generators and, moreover, the power generator comprises prefabricated cooling tubes for cooling the thermo electric generators.

The invention will now be described in further details with reference to an example and drawings wherein:
Fig. 1 depicts a cooling tube for cooling the thermo electric generators;
Fig. 2 depicts a cross section of a power generator according to the invention; and
Fig. 3 depicts thermo electric generators mounted on a substrate.

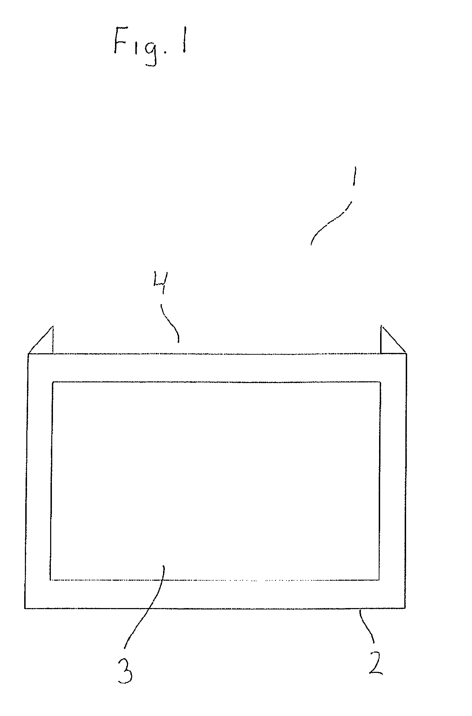

Figure 1 shows a cooling tube 1 for a cooling medium such as water. The tube 2 is made from copper or aluminum and further comprises a layer of insulation 3. For the purpose of improving the cooling tube 1 capability to cool the thermo electric generators the cooling tube 2 comprises a track 4 for mounting the thermo electric generators.

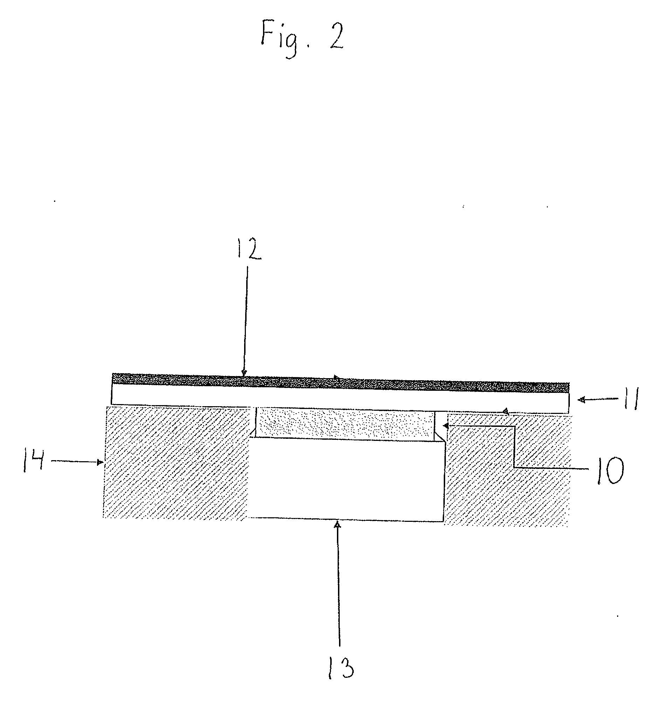

Figure 2 shows a cross section of a power generator according to the invention. The power generator comprises a thermo electric generator 10 that are attached to a copper strip 11 constituting the heat absorbing substrate. The thermo electric generator 10 is attached with the heat receiving side to the heat releasing side of the substrate 11. In this embodiment the heat absorbing side of the substrate 11 is applied with a heat absorbing coating 12 to improve the heat transfer properties of the substrate 11. The cooling side of the thermo electric generator 10 is in contact with a tube 13 in which a cooling medium, such as water, flows. The tube 13 is connected with a cooling system that provides for an efficient cooling of the cooling side of the thermo electric generator 10. To improve the capacity of the power generator the thermo electric generator 10 and the tube 13 are insulated with an insulating material 14.

The thermo electric generator 10 is attached to the substrate 11 and the tube 13 by means of heat conductive paste or glue. The wiring connecting the thermo electric generator 10 with other thermo electric generators and an inverter is not visible in the figure.

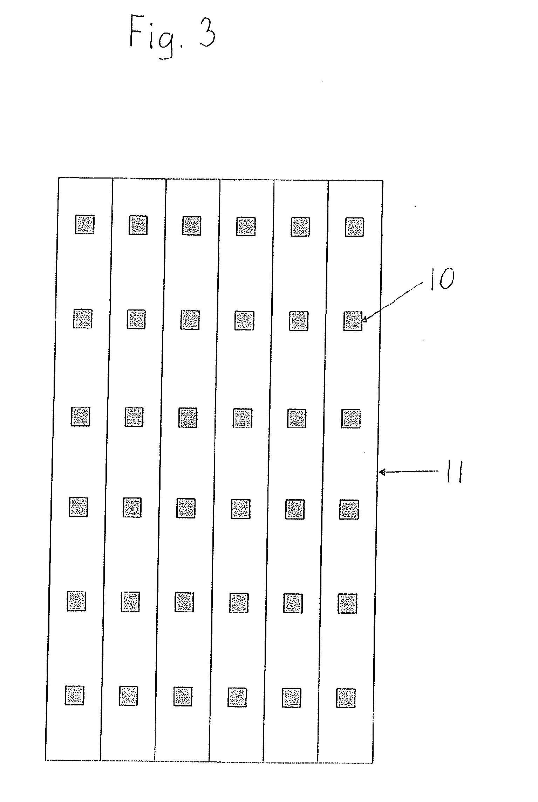

Figure 3 shows the principles of a power generator comprising copper strips 11 as heat absorbing substrate to which the thermo electric generators 10 are attached. Each strip 11 carries six thermo electric generators and all together the six strips 11 carries thirty six thermo electric generators 10. Consequently, figure 3 schematically depicts a power generator with thirty six thermo electric generators.

The power generator according to the invention utilizes thermo electric generators and the efficiency η_{c} of a thermo electric generator can be calculated according to η_{c} = 1 - T_{low}(K)/T_{high}(K);
where T_{low} is the temperature in Kelvin on the cooling side of the thermo electric generator, and T_{high} is the temperature in Kelvin on the heat receiving side of the thermo electric generator.

If e.g. T_{low} is 293,15K and T_{high} is 473,15K this gives that η_{c} = 0,38 which equals an efficiency of 38%. However, an increase in the difference between T_{low} and T_{high} will also increase the efficiency.

In reality it has been discovered that it is realistic to achieve an efficiency of about 10% to 25% of η_{c}. This fact has to be taken into consideration during the design of the power generation. Moreover, it should be taken into consideration where a power generator is intended to be used as the effect in the solar radiation varies significant, e.g. between 600 and 1000Watt/m² in northern Europe and up to between 1200 and 1300Watt/m² in Sahara. Consequently, it is estimated that when the solar radiation on the heat absorbing substrate is about 600Watt/m², which will correspond to the situation in northern Europe, the effect on each thermo electric generator when there is calculated 4Watt will require 40Watt input when the efficiency is 10%. A thermo electric generator of 7Watt or 7,5Watt will, thus, require 70Watt or 75Watt, respectively, for maximum performance.

### Example

In the following was used a heat absorbing substrate with a heat absorbing area of 2,2m² and the heat absorbing substrate was provided as strips with a total length of 16m were the strips had a width of 0,14m. The strips were Custrlps delivered from the company BATEC, Denmark. Custrips are made from copper and have a heat absorbing side that is coated with a black heat absorbing material.

A number of thermo electric generators with a heat receiving areal 900mm² (30 x 30mm) were mounted on the heat releasing side of the strips. These thermo electric generators were intended to work with a maximum temperature of about 200°C. The maximum effect for each of the thermo electric generator was 4Watt, TEG-4 delivered from the company TEGPOWER, USA.

16 thermo electric generators each having a maximum output of 4Watt was mounted on the 16m long strips by use of heat conductive pasta FisherElectric from the company 3M. The thermo electric generators were mounted with a mutual distance of 0,5m on the strips which was in accordance with the fact that the input effect to the strips was found to be approximately 640Watt/m² (measured on the test location, Karise, Denmark). The strips and the thermo electric generators was mounted in boxes having sides of glass facing the sun, which also increased the heat input to the thermo electric generators.

When exposed to sun the power generator was able to deliver approximately 100Watt of useable electric power.

Alternatively it would be possible to use thermo electric generators with a heat receiving areal of 1600mm² (40 x 40mm), which have a maximum effect of 7Watt. Thus, fewer thermo electric generators could have been used or a higher effect could have been achieved. Although the present invention has been described with reference to only a few embodiments, it will easily be envisaged by a skilled person that several other embodiments and variations are possible within the scope of the claims.

## Claims

1. A power generator comprising a heat absorbing substrate with a first heat absorbing side and a second heat releasing side and one or more thermo electric generators having a first heat receiving side and a second cooling side, wherein the one or more thermo electric generators are in contact with the heat releasing side of the heat absorbing substrate with their first heat receiving side to allow heat to be transferred from the heat absorbing substrate to the one or more thermo electric generators and where the area of the heat releasing side in contact with and surrounding a thermo electric generator is at least four times larger than the area of the first heat receiving side of the thermo electric generator.

2. A power generator according to claim 1, wherein at least two thermo electric generators are in contact with the heat releasing side of the heat absorbing substrate and the mutual distance between each thermo electric generator is at least 5 cm.

3. A power generator according to claim 1 or 2, wherein the cooling side of the thermo electric generator is in contact with a cooling media.

4. A power generator according to any of the preceding claims, wherein the difference in temperature between the first heat receiving side and the second cooling side of the thermo electric generator is in the range of 30 to 300K, preferably in the range of 50 to 250K.

5. A power generator according to any of the preceding claims, wherein at least a part of the heat absorbing substrate comprises copper, aluminium.

6. A power generator according to any of the preceding claims, wherein each thermo electric generator has a maximum effect of from 3 to 10Watt.

7. A power generator according to any of the preceding claims, wherein the power generator comprises 5 to 40 thermo electric generators, preferably 10-30 thermo electric generators.

8. A power generator according to any of the preceding claims, wherein the thermo electric generators are electrical connected in series.

9. A power generator according to any of the preceding claims, wherein the heat absorbing substrate is prefabricated as strips in a heat conducting material such as copper or aluminium.

10. A power generator according to any of the preceding claims, wherein the heat absorbing substrate and the thermo electric generators are placed in a box having at least one side made from glass.

11. A power generator according to any of the preceding claims, wherein the power generator comprises a cooling module adapted to fit with the cooling side of the thermo electric generators.

12. A power generator according to any of the preceding claims, wherein the heat absorbing substrate is prefabricated strips, preferably adapted with tracks for mounting thermo electric generators, and where the power generator further comprises prefabricated cooling tubes for cooling the thermo electric generators.
